# FASCICULE DE BREVET EUROPEEN

(11) **EP 3 766 094 B1**
(45) Date de publication et mention de la délivrance du brevet: **27.04.2022**
(21) Numéro de dépôt: 19710754.3
(22) Date de dépôt: 18.02.2019
(51) Int. Cl.: H01L 21/762, H01L 21/02, H01L 41/312

(54) **PROCÉDÉ DE PRÉPARATION D'UNE COUCHE MINCE DE MATÉRIAU FERROÉLECTRIQUE À BASE D'ALCALIN**
VERFAHREN ZUR HERSTELLUNG EINER DÜNNSCHICHT AUS EINEM FERROELEKTRIKUM AUF ALKALIBASIS
METHOD FOR PRODUCING A THIN FILM CONSISTING OF AN ALKALINE-BASED FERROELECTRIC MATERIAL

(30) Priorité: 12.03.2018 FR 1852122
(43) Date de publication de la demande: 20.01.2021
(73) Titulaire: SOITEC, 38190 Bernin (FR)
(72) Inventeur: DROUIN, Alexis, 38530 La Buissiere (FR)
(74) Mandataire: IP Trust
(86) Numéro de dépôt international: PCT/FR2019/050356
(87) Numéro de publication internationale: WO 2019/175487

(56) Documents cités:
- FR-A1- 2 914 492
- US-A1- 2010 088 868

## Description

### DOMAINE DE L'INVENTION

La présente invention concerne un procédé de préparation d'une couche mince de matériau ferroélectrique à base d'alcalin. Plus particulièrement, elle concerne un procédé de préparation permettant de maintenir ou établir le caractère monodomaine du matériau ferroélectrique dans la couche mince du produit final. Ce procédé de préparation est utilisé, par exemple, pour des applications dans les domaines de la microélectronique, de la micromécanique, de la photonique...

### ARRIERE PLAN TECHNOLOGIQUE DE L'INVENTION

En préambule on rappelle qu'un matériau ferroélectrique est un matériau qui possède une polarisation électrique à l'état naturel, polarisation qui peut être renversée par l'application d'un champ électrique extérieur. On appelle domaine ferroélectrique, chaque région d'un seul tenant du matériau dans lequel la polarisation est uniforme (tous les moments dipolaires sont alignés parallèlement les uns aux autres suivant une direction donnée). Un matériau ferroélectrique peut donc être caractérisé de « monodomaine » dans le cas où ce matériau est constitué d'une seule région dans laquelle la polarisation est uniforme ou de « multidomaine » dans le cas où le matériau ferroélectrique comprend une pluralité de régions présentant des polarités pouvant être différentes.

On connaît de l'état de la technique différents procédés permettant de former une couche mince de matériau ferroélectrique. Il peut s'agir, par exemple, d'une technique d'épitaxie par jet moléculaire (« Molecular Beam Epitaxy » en anglais), de pulvérisation plasma (« Plasma Sputtering » en anglais), dépôt par plasma (« Laser Pulsed Déposition » en anglais), ou encore de l'application de la technologie Smart Cut^{™} selon laquelle une couche mince est prélevée d'un substrat massif en matériau ferroélectrique par fracture au niveau d'une zone fragile (ou plan de fragilisation) formée dans le substrat massif par implantation d'espèces légères.

La présente invention concerne plus particulièrement la préparation d'une couche mince ferroélectrique à base d'alcalin obtenue par l'application d'un tel procédé.

Selon ce procédé, et après l'étape de prélèvement d'une couche, il est souvent nécessaire d'appliquer des traitements à la couche mince afin d'en améliorer l'état de surface, sa qualité cristalline, son adhésion à un support, ou d'en modifier son épaisseur.

Il est connu d'utiliser, après l'étape de prélèvement d'une couche, une étape de traitement thermique pour améliorer les propriétés mentionnées ci-dessus de la couche mince. On connaît ainsi du document FR 2863771 un procédé pour la préparation d'une couche mince constitué principalement de deux étapes : une étape de préparation de la surface de la couche mince (telle qu'un polissage par exemple) et une étape de traitement thermique (telle qu'un recuit thermique par exemple).

De manière à améliorer au mieux les propriétés de la couche mince, ainsi que ses propriétés d'adhésion avec un support, il est nécessaire de faire un traitement thermique à une température suffisamment importante, les propriétés précitées de la couche mince étant d'autant plus améliorées que la température du traitement est importante. Toutefois, cela implique très souvent, pour obtenir un résultat satisfaisant, de dépasser la température de Curie du matériau.

Pour rappel, la température de Curie est la température au-delà de laquelle le matériau perd ses propriétés ferroélectriques. Lorsqu'il repasse en dessous de la température de Curie, lors de son refroidissement, le matériau reprend des propriétés ferroélectriques. Toutefois, les propriétés ferroélectriques reprises sont généralement différentes de celles initiales et cela peut conduire notamment à la formation d'une pluralité de domaines ferroélectriques au sein de la couche mince, lui attribuant ainsi un caractère multidomaine.

Ce caractère multidomaine du matériau ferroélectrique est problématique, car il rend les caractéristiques du matériau inhomogène, ce qui peut affecter les performances des dispositifs qui sont appelés à être formés sur/dans la couche mince. C'est notamment le cas des dispositifs acoustiques à ondes de surface (SAW), la propagation des ondes étant affectée par la polarité du matériau piézoélectrique qu'elles traversent.

C'est pourquoi il n'est généralement pas recommandé d'exposer une couche en matériau ferroélectrique à une température qui excède sa température de Curie.

On connaît du document FR2914492 un procédé de fabrication d'une couche mince de matériau ferroélectrique par la technologie Smart Cut. Ce document applique un champ électrique à la couche mince de manière à améliorer ou à restaurer ses propriétés ferroélectriques.

Toutefois, pour être facilement applicable, ce procédé nécessite de disposer d'électrodes sur chacune des faces de la couche mince, ce qui n'est pas toujours le cas.

Par ailleurs, les documents US2010/088868 A, FR-2914492 A1 décrivent des procédés de transfert d'une couche mince de matériau ferroélectrique d'un substrat donneur vers un substrat support.

### OBJET DE L'INVENTION

Un but de l'invention est de proposer un procédé de préparation de couche mince de matériau ferroélectrique à base d'alcalin et qui soit monodomaine.

### BREVE DESCRIPTION DE L'INVENTION

En vue de la réalisation de ce but, l'objet de l'invention propose un procédé de préparation d'une couche mince en matériau ferroélectrique à base d'alcalin, présentant une température de Curie déterminée, transférée d'un substrat donneur sur un substrat support par une technique de transfert incluant une implantation d'espèces atomique dans le substrat donneur pour générer un plan de fragilisation, la couche mince présentant une première face libre et une deuxième face disposée sur le substrat support.

Selon l'invention, le procédé de préparation de la couche mince comprend un premier traitement thermique de la couche mince transférée à une température supérieure à la température de Curie déterminée, la couche mince présentant un caractère multidomaine à l'issue du premier traitement thermique. Le procédé comprend également l'introduction, après le premier traitement thermique, de protons dans la couche mince, suivi de l'application d'un deuxième traitement thermique de la couche mince à une température inférieure à la température de Curie déterminée pour générer un champ électrique interne conduisant à rendre la couche mince monodomaine.

Selon d'autres caractéristiques avantageuses et non limitatives de l'invention, prises seules ou selon toute combinaison techniquement réalisable :
- les espèces atomiques implantées sont des ions d'hydrogène et/ou d'hélium ;
- la technique de transfert comporte l'assemblage du substrat donneur avec le substrat support et le détachement de la couche mince au niveau du plan de fragilisation ;
- l'introduction de protons dans la couche mince est réalisée par échange protonique ;
- l'échange protonique est réalisé par l'immersion d'au moins la couche mince dans un bain d'acide benzoïque à une température typiquement comprise entre 200 et 300°C pendant 10 min à 30 h ;
- l'introduction des protons dans la couche mince est réalisée par implantation ionique ou par implantation plasma ;
- le premier traitement thermique s'effectue pendant une durée comprise entre 30 minutes et 10 heures ;
- le premier et le deuxième traitement thermique s'effectuent dans une atmosphère oxydante ou neutre ;
- le deuxième traitement thermique s'effectue à une température à moins de 100°C, préférentiellement à moins de 50°C ou de 10°C de la température de Curie déterminée et pendant une durée comprise entre 30 min et 10 heures ;
- le procédé de préparation de la couche mince comprend une étape de polissage appliquée sur la première face de la couche mince ;
- le polissage s'effectue après le premier traitement thermique ;
- le polissage s'effectue après le deuxième traitement thermique ;
- le polissage est un polissage mécano-chimique.
- le substrat donneur est en matériau ferroélectrique alcalin à base de lithium ;
- le substrat donneur est en LiTa03 ou en LiNb03 ;
- le matériau ferroélectrique présente une direction cristalline 42°RY ;
- le matériau du substrat support est du silicium ;

### BREVE DESCRIPTION DES DESSINS

D'autres caractéristiques et avantages de l'invention ressortiront de la description détaillée de l'invention qui va suivre en référence aux figures annexées sur lesquelles :
- les figures 1A à 1D présentent un premier mode de réalisation d'un procédé conforme à l'invention ;
- les figures 2A à 2D présentent un deuxième mode de réalisation d'un procédé conforme à l'invention ;
- les figures 3A à 3C représente schématiquement un procédé de préparation d'une couche mince conforme à l'invention.

### DESCRIPTION DETAILLEE DE L'INVENTION

Par souci de simplification de la description à venir, les mêmes références sont utilisées pour des éléments identiques ou assurant la même fonction dans les différents modes de mise en œuvre exposés du procédé.

Les figures sont des représentations schématiques qui, dans un objectif de lisibilité, ne sont pas à l'échelle. En particulier, les épaisseurs des couches ne sont pas à l'échelle par rapport aux dimensions latérales de ces couches.

L'expression « coefficient de dilatation thermique » employée dans la suite de cette description en relation à une couche ou à un substrat fait référence au coefficient de dilatation selon une direction définie dans le plan principal définissant cette couche ou ce substrat. Si le matériau est anisotrope, la valeur du coefficient retenue sera celle de plus grande amplitude. La valeur du coefficient est celle mesurée à température ambiante.

L'invention concerne un procédé de préparation d'une couche mince 3 en un matériau ferroélectrique à base d'alcalin, la couche présentant une température de Curie déterminée, transférée d'un substrat donneur 1 sur un substrat support 7 par une technique de transfert incluant une implantation d'espèces légères dans le substrat donneur 1. Plusieurs modes de réalisation existent pour effectuer ce transfert.

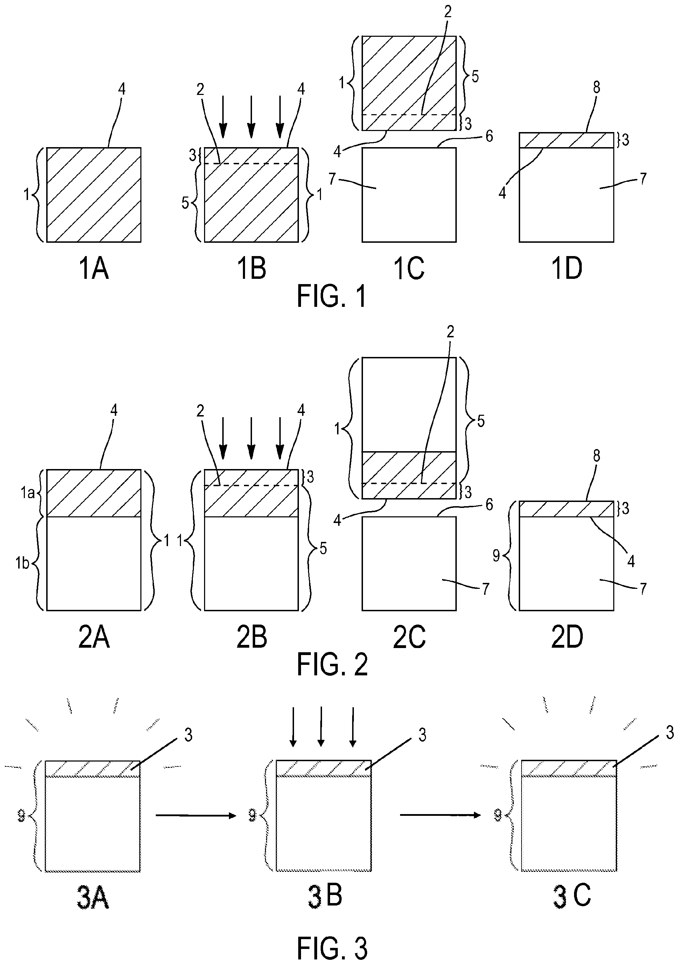

Suivant un premier mode de réalisation représenté sur les figures 1A à 1D, le substrat donneur 1 est composé d'un bloc massif et monodomaine de matériau ferroélectrique à base d'alcalin tel que du KTiOPO4, KNb03, NaNb03, KTa03, NaTa03 et plus particulièrement ceux à base de lithium, par exemple de LiTa03 (de température de Curie typiquement compris entre 600°C et 650°C), de LiNb03 (de température de Curie d'environ 1145°C). On pourrait tout à fait envisager, dans le cadre de la présente invention, que le substrat donneur 1 présente un caractère multidomaine.

Le substrat donneur 1 peut prendre la forme d'une plaquette, circulaire, de dimension normalisée, par exemple de 150 mm ou 200 mm de diamètre. Mais l'invention n'est nullement limitée à ces dimensions ou à cette forme. Le substrat donneur 1 peut avoir été prélevé d'un lingot de matériaux ferroélectrique, ce prélèvement ayant été réalisé de manière à ce que le substrat donneur 1 présente une orientation cristalline prédéterminée. L'orientation est choisie en fonction de l'application visée. Ainsi, il est usuel de choisir une orientation 42°RY dans le cas où l'on souhaite exploiter les propriétés de la couche mince pour former un filtre SAW. Mais l'invention n'est nullement limitée à une orientation cristalline particulière.

Quelle que soit l'orientation cristalline du substrat donneur 1, le procédé comprend l'introduction, dans le substrat donneur 1, d'au moins une espèce atomique. Cette introduction peut correspondre à une implantation, c'est-à-dire, un bombardement ionique de la face plane 4 du substrat donneur 1 par des espèces telles que des ions d'hydrogène et/ou hélium.

De façon connue en soi, et comme cela est représenté sur la figure 1B, les ions implantés ont pour but de former un plan de fragilisation 2 délimitant une couche mince 3 de matériau ferroélectrique à transférer, située du côté de la face 4, et une autre partie 5 formant le reste du substrat.

La nature, la dose des espèces implantées et l'énergie d'implantation sont choisies en fonction de l'épaisseur de la couche que l'on souhaite transférer et des propriétés physico-chimiques du substrat donneur. Dans le cas d'un substrat donneur 1 en LiTa03, on pourra ainsi choisir d'implanter une dose d'hydrogène comprise entre 1^{E}16 et 5^{E}17 at/cm² avec une énergie comprise entre 30 et 300keV pour délimiter une couche mince 3 de l'ordre de 200 à 2000 nm.

Dans une étape suivante, représentée sur la figure 1C, on assemble la face plane 4 du substrat donneur 1 avec une face 6 d'un substrat support 7. Le substrat support 7 peut présenter la même dimension et la même forme que celles du substrat donneur. Pour des raisons de disponibilité et de coût, le substrat support 7 est une plaquette de silicium, monocristallin ou polycristallin. Mais plus généralement, le substrat support 7 peut être constitué de tout matériau, par exemple du silicium, du saphir ou du verre, et présenter toute forme.

Lorsque le procédé est mis œuvre en vue de la réalisation de dispositifs pour des applications dans le domaine radiofréquence, il peut être avantageux de choisir un substrat support 7 qui soit hautement résistif, présentant par exemple une résistivité supérieure à 1000 ohm.cm. On peut également disposer sur le substrat support 7 une couche de piégeage de charges, telle qu'une couche en silicium polycristallin, de quelques microns d'épaisseur par exemple.

Préalablement à cette étape d'assemblage, il peut être envisagé de préparer les faces des substrats à assembler par une étape de nettoyage, brossage, séchage, polissage, ou une activation plasma.

L'étape d'assemblage peut correspondre à la mise en contact intime du substrat donneur 1 avec le substrat support 7 par adhésion moléculaire et/ou collage électrostatique. Optionnellement, pour faciliter l'assemblage des deux substrats 1, 7 notamment lorsqu'ils sont assemblés par collage direct, au moins une couche intermédiaire peut être formée préalablement à l'assemblage, soit sur la face plane 4 du substrat donneur 1, soit sur la face plane 6 à assembler du substrat support 7, soit sur les deux. Cette couche intermédiaire est par exemple constituée d'oxyde de silicium, de nitrure de silicium ou encore de silicium poly-crystallin et avoir une épaisseur comprise entre quelques nanomètres et quelques microns. La couche intermédiaire peut être élaborée selon les différentes techniques connues de l'état de l'art, telles des traitements thermiques d'oxydation ou de nitruration, des dépôts chimiques (PECVD, LPCVD...) , etc. Cette couche intermédiaire lorsqu'elle est polycristalline est configurée, en épaisseur par exemple, pour conserver ses propriétés polycristallines à l'issue des différents traitements thermiques du procédé de préparation.

A l'issue de cette étape d'assemblage, on dispose de l'ensemble représenté sur la figure 1C comprenant les deux substrats associés, la face plane 6 du substrat support 7 adhérant à la face plane 4 du substrat donneur 1.

L'ensemble est alors traité pour détacher la couche mince 3 de matériau ferroélectrique du substrat donneur 1, par exemple par clivage au niveau du plan de fragilisation 2.

Cette étape de détachement peut ainsi comprendre l'application d'un traitement thermique dans une gamme de température de l'ordre de 80°C à environ 300° pour permettre le transfert de la couche mince 3 sur le substrat support 7. En remplacement ou en complément du traitement thermique, cette étape peut comprendre l'application d'une lame, un jet de fluide gazeux ou liquide, ou plus généralement de tout effort mécanique au niveau du plan de fragilisation 2.

Suite à l'étape de détachement, on obtient la structure 9 représentée à la figure 1D. Cette structure 9 comprend la couche mince 3 de matériau ferroélectrique comprenant une première face libre 8 et une deuxième face 4 disposée sur le substrat support 7. La couche mince 3 peut de manière indifférente présenter un caractère monodomaine ou multidomaine.

Les figures 2A à 2D représentent un deuxième mode de réalisation de la structure 9, particulièrement adapté à la réalisation d'une structure 9 hétérogène, dans laquelle la couche mince 3 présente un coefficient de dilatation thermique bien différent de celui du substrat support 7, par exemple présentant une différence de plus de 10%.

En référence à la figure 2A, le substrat donneur 1 est dans ce cas composé d'une couche épaisse de matériau ferroélectrique à base d'alcalin la, possédant les mêmes propriétés que celles décrites pour le bloc massif de matériaux ferroélectrique en relation avec le premier mode de réalisation, et d'un substrat manipulateur 1b.

Le substrat manipulateur 1b est avantageusement constitué d'un matériau (ou d'une pluralité de matériaux) lui conférant un coefficient de dilatation thermique proche de celui composant le substrat support 7. Par « proche », on signifie que la différence de coefficient de dilatation thermique du substrat manipulateur 1b et de celui du support est moindre, en valeur absolue, que la différence de dilatation thermique du bloc massif du matériau ferroélectrique et de celui du substrat support 7.

Préférentiellement, le substrat manipulateur 1b et le substrat support présentent un coefficient de dilatation thermique identique. Lors de l'assemblage du substrat donneur et du support, on forme une structure apte à supporter un traitement thermique à une température relativement élevée, pouvant même dépasser la température de Curie de la couche épaisse de matériau ferroélectrique à base d'alcalin la. Pour des raisons de simplicité de mise en œuvre, cela peut être obtenu en choisissant le substrat manipulateur 1b pour qu'il soit constitué du même matériau que celui du substrat support 7.

Pour former le substrat donneur 1 de ce mode de réalisation, on assemble préalablement un bloc massif de matériau ferroélectrique avec le substrat manipulateur la, par exemple selon une technique de collage par adhésion moléculaire telle que cela a été décrit préalablement. Puis, on forme la couche de matériau ferroélectrique la par amincissement, par exemple par meulage et/ou polissage mécano-chimique et/ou gravure. Avant l'assemblage on peut avoir prévu la formation d'une couche d'adhésion (par exemple par dépôt d'oxyde de silicium et/ou de nitrure de silicium) sur l'une et/ou l'autres des faces mises en contact. L'assemblage peut comprendre l'application d'un traitement thermique de faible température (compris par exemple entre 50 et 300°C, typiquement 100°C) permettant de renforcer suffisamment l'énergie de collage pour permettre l'étape suivante d'amincissement.

Le substrat manipulateur 1b est choisi pour présenter une épaisseur sensiblement équivalente à celle du substrat support 7. L'étape d'amincissement est conduite de telle sorte que la couche épaisse la présente une épaisseur suffisamment faible pour que les contraintes générées lors des traitements thermiques appliqués dans la suite du procédé soient d'intensité réduite. Dans le même temps, cette épaisseur est suffisamment importante pour pouvoir y prélever la couche mince 3, ou une pluralité de telles couches. Cette épaisseur peut par exemple être comprise entre 5 et 400 microns.

Les étapes suivantes du procédé de ce second mode de mise en œuvre sont équivalentes à celles des étapes décrites dans le premier mode de réalisation. On procède à l'implantation d'espèces atomiques au sein de la couche épaisse la pour générer un plan de fragilisation 2 qui marque la séparation de la couche mince 3 du reste 5 du substrat donneur 1, comme cela est représenté sur la figure 2B. Cette étape est suivie de l'étape d'assemblage du substrat donneur 1 sur le substrat support 7, tel que cela est représenté sur la figure 2C. On détache ensuite la couche mince 3 du reste du substrat 5 pour obtenir la structure 9 représentée sur la figure 2D.

Ce mode de réalisation est avantageux en ce que l'assemblage formé du substrat donneur 1 et du support 7 peut être exposé à une température bien plus élevée que celle appliquée dans le cadre du premier mode de réalisation, sans risque de fracture incontrôlée de l'un des substrats ou de délamination du substrat donneur 1 de la couche mince 3. La structure équilibrée, en termes de coefficient de dilatation thermique de cet assemblage, permet ainsi de faciliter l'étape de détachement de la couche mince 3 en exposant l'assemblage à une température relativement élevée, par exemple comprise entre 100 et 500 °C ou plus. Cette température peut être supérieure à celle de Curie de la couche mince 3, car le caractère monodomaine de cette couche mince 3 pourra être rétablie au cours des étapes de préparation dont la description suit.

Quel que soit le mode de mise en œuvre choisi, et comme cela a été précisé en introduction de cette demande, des étapes de préparation de la couche mince 3 sont ensuite nécessaires pour améliorer la qualité cristalline et de surface, et d'adhésion de la couche mince 3.

Le procédé de préparation de la couche mince 3, illustré par la figure 3, comporte un premier traitement thermique (Fig. 3A) appliqué à la couche mince 3 transférée. Ce traitement thermique permet de guérir des défauts cristallins qui peuvent avoir été générés au cours des étapes précédentes d'implantation et de fracture. En outre, il contribue à consolider le collage entre la couche mince 3 et le support 7. Selon l'invention, ce premier traitement thermique porte la structure à une température supérieure à la température de Curie de la couche mince 3, tout en ne dépassant pas bien entendu la température de fusion de cette couche, pendant une durée typiquement comprise entre 30 minutes et 10h heures. Ce traitement thermique est préférentiellement réalisé en exposant la face libre de la couche mince 3 à une atmosphère gazeuse oxydante ou neutre, c'est à dire sans recouvrir cette face de la couche mince d'une couche de protection.

Ce premier traitement thermique s'effectuant à une température supérieure à la température de Curie de la couche mince 3, celle-ci perd alors temporairement ses propriétés ferroélectriques. Lorsque la température de la couche mince 3 repasse en dessous de sa température de Curie, lors de son refroidissement, de nouvelles propriétés ferroélectriques sont obtenues. Ces nouvelles propriétés ferroélectriques sont généralement différentes de celles initiales et peuvent varier localement attribuant ainsi à la couche mince une caractéristique multidomaine.

A l'issue de ce premier traitement thermique, la couche mince 3 possède un caractère multidomaine. La couche mince 3 possède toutefois une meilleure qualité cristalline ainsi qu'un meilleur degré d'adhésion avec le support 7 qu'une même couche mince qui aurait été traitée par un premier traitement thermique réalisé à une température inférieure à sa température de Curie.

L'étape suivante a pour but de rétablir le caractère monodomaine de la couche mince 3. Cette étape, comporte l'introduction, après le premier traitement thermique, de protons (Fig. 3B), par exemple des protons d'hydrogène, dans la couche mince 3 suivi de l'application d'un deuxième traitement thermique (Fig. 3C) de la couche mince 3 à une température inférieure à sa température de Curie.

L'introduction de protons a pour but de générer un gradient de charges positives dans la couche mince 3 afin d'induire un champ électrique interne excédant le champ coercitif interne. On oriente ainsi le matériau dans la direction de ce champ interne pour le rendre monodomaine à l'échelle de la couche mince 3.

L'introduction de protons peut être faite de plusieurs façons. Il peut s'agir d'un échange protonique réalisé, par exemple, par l'immersion d'au moins la couche mince 3 dans un bain d'acide benzoïque à une température typiquement comprise entre 200 et 300°C pendant 10 min à 30 h.

L'introduction de protons peut aussi être réalisée par implantation ionique ou par implantation plasma.

Le deuxième traitement thermique permet de faciliter la réorientation du champ électrique interne en favorisant la diffusion des protons, ce qui entraîne l'amélioration du gradient de charge, et en réduisant la valeur du champ coercitif.

On pourra se référer aux documents « Discussion of domain inversion in LiNb03, L. Huang, NAF Jaeger, Applied physics letters, 1994 » et « Singledomain surface layers formed by heat treatment of protonexchanged multidomain LiTa03 crystals, K. Nakamura A. Tourlog, Applied physics letters, 1993 » pour plus de précision sur les mécanismes qui entrent en jeu au cours de ce traitement thermique, et des raisons pour lesquelles ces étapes permettent de fournir une couche monodomaine.

Le deuxième traitement thermique porte la structure à une température inférieure à moins de 100°C, préférentiellement à moins de 50°C ou de 10°C, de la température de Curie de la couche mince 3, préférentiellement pendant une durée comprise entre 30 minutes et 10h heures. Ce deuxième traitement thermique, tout comme le premier traitement thermique, est préférentiellement réalisé en exposant la face libre de la couche mince 3 à une atmosphère gazeuse oxydante ou neutre.

A l'issue de ce deuxième traitement thermique, la couche mince 3 présente alors un caractère monodomaine.

Le procédé de préparation peut comporter également, juste après le premier traitement thermique ou après le deuxième traitement thermique, un amincissement de la couche mince 3. Cet amincissement peut correspondre au polissage de la première face libre 8 de la couche mince 3, par exemple par des techniques d'amincissement mécanique, mécano-chimique et/ou de gravure chimique. Il permet de préparer la face libre 8 pour qu'elle présente une rugosité faible, par exemple inférieure à 0,5nm RMS 5x5 µm par mesure par force atomique (AFM) et d'enlever une partie superficielle de la première face libre 8 de la couche mince 3 susceptible de contenir des défauts résiduels.

On évitera d'exposer la couche mince, après ce deuxième traitement thermique, à des températures excédant sa température de Curie, de manière à maintenir la propriété monodomaine qui a été rétablie.

Bien entendu l'invention n'est pas limitée aux modes de mise en œuvre décrits et on peut y apporter des variantes de réalisation sans sortir du cadre de l'invention tel que défini par les revendications.

## Revendications

1. Procédé de préparation d'une couche mince (3) en matériau ferroélectrique à base d'alcalin, présentant une température de Curie déterminée, transférée d'un substrat donneur (1) sur un substrat support (7) par une technique de transfert incluant une implantation d'espèces atomiques dans le substrat donneur (1) pour générer un plan de fragilisation (2), la couche mince (3) présentant une première face libre (8) et une deuxième face (4) disposée sur le substrat support (7) ; le procédé de préparation de la couche mince (3) étant **caractérisé en ce qu'**il comprend
- un premier traitement thermique de la couche mince (3) transférée à une température supérieure à la température de Curie déterminée, la couche mince (3) présentant un caractère multidomaine à l'issue du premier traitement thermique ;
- l'introduction, après le premier traitement thermique, de protons dans la couche mince (3), suivi de l'application d'un deuxième traitement thermique de la couche mince (3) à une température inférieure à la température de Curie déterminée pour générer un champ électrique interne conduisant à rendre la couche mince (3) monodomaine.

2. Procédé selon la revendication précédente, dans lequel les espèces atomiques implantées sont des ions d'hydrogène et/ou hélium.

3. Procédé selon l'une des revendications précédentes, dans lequel la technique de transfert comporte l'assemblage du substrat donneur (1) avec le substrat support (7) et le détachement de la couche mince (3) au niveau du plan de fragilisation (2).

4. Procédé selon l'une des revendications précédentes, dans lequel l'introduction de protons dans la couche mince (3) est réalisée par échange protonique.

5. Procédé selon la revendication précédente, dans lequel l'échange protonique est réalisé par l'immersion d'au moins la couche mince (3) dans un bain d'acide benzoïque à une température typiquement comprise entre 200 et 300°C pendant 10 min à 30 h.

6. Procédé selon l'une des revendications 1 à 3, dans lequel l'introduction des protons dans la couche mince (3) est réalisée par implantation ionique ou par implantation plasma.

7. Procédé selon l'une des revendications précédentes, dans lequel le premier traitement thermique s'effectue pendant une durée comprise entre 30 minutes et 10 heures.

8. Procédé selon l'une des revendications précédentes, dans lequel le premier et le deuxième traitement thermique s'effectuent dans une atmosphère oxydante ou neutre.

9. Procédé selon l'une des revendications précédentes, dans lequel le deuxième traitement thermique s'effectue à une température à moins de 100°C, préférentiellement à moins de 50°C ou de 10°C de la température de Curie déterminée et pendant une durée comprise entre 30 min et 10 heures.

10. Procédé selon l'une des revendications précédentes, dans lequel le procédé de préparation de la couche mince (3) comprend une étape de polissage appliquée sur la première face (8) de la couche mince (3).

11. Procédé selon l'une des revendications précédentes, dans lequel le polissage s'effectue après le premier traitement thermique ou après le deuxième traitement thermique.

12. Procédé selon l'une des revendications précédentes, dans lequel le substrat donneur (1) est en matériau ferroélectrique à base de lithium.

13. Procédé selon la revendication précédente, dans lequel le substrat donneur (1) est en LiTa03 ou en LiNbO3.

14. Procédé selon l'une des revendications précédentes, dans lequel le matériau ferroélectrique présente une direction cristalline 42°RY.

15. Procédé selon l'une des revendications précédentes, dans lequel le matériau du substrat support (7) est du silicium.

## Patentansprüche

1. Verfahren zur Herstellung einer Dünnschicht (3) aus einem Ferroelektrikum auf Alkalibasis, die eine bestimmte Curie-Temperatur aufweist, die von einem Donorsubstrat (1) auf ein Trägersubstrat (7) durch eine Transfertechnik übertragen wird, was eine Implantation von atomaren Spezies in das Donorsubstrat einschließt (1), um eine Schwächungsebene (2) zu erzeugen, wobei die Dünnschicht (3) eine erste freie Fläche (8) und eine zweite Fläche (4) aufweist, die auf dem Trägersubstrat (7) angeordnet ist; wobei das Verfahren zur Herstellung der Dünnschicht (3) **dadurch gekennzeichnet ist, dass** es Folgendes umfasst:
- eine erste Wärmebehandlung der übertragenen Dünnschicht (3) bei einer Temperatur oberhalb der bestimmten Curie-Temperatur, wobei die Dünnschicht (3) am Ende der ersten Wärmebehandlung einen Multidomänencharakter aufweist;
- das Einbringen von Protonen nach der ersten Wärmebehandlung in die Dünnschicht (3), gefolgt von der Anwendung einer zweiten Wärmebehandlung der Dünnschicht (3) bei einer Temperatur unterhalb der bestimmten Curie-Temperatur, um ein inneres elektrisches Feld zu erzeugen, das dazu führt, dass die Dünnschicht (3) monodomal wird.

2. Verfahren nach vorhergehendem Anspruch, wobei die implantierten atomaren Spezies Wasserstoff- und/oder Heliumionen sind.

3. Verfahren nach einem der vorhergehenden Ansprüche, wobei die Transfertechnik das Zusammenfügen des Donorsubstrats (1) mit dem Trägersubstrat (7) und das Ablösen der Dünnschicht (3) im Bereich der Schwächungsebene (2) umfasst.

4. Verfahren nach einem der vorhergehenden Ansprüche, wobei das Einbringen von Protonen in die Dünnschicht (3) durch Protonenaustausch erfolgt.

5. Verfahren nach vorhergehendem Anspruch, wobei der Protonenaustausch durch Eintauchen mindestens der Dünnschicht (3) in ein Bad aus Benzoesäure bei einer Temperatur von typischerweise zwischen 200 und 300 °C für 10 Minuten bis 30 Stunden durchgeführt wird.

6. Verfahren nach einem der Ansprüche 1 bis 3, wobei das Einbringen der Protonen in die Dünnschicht (3) durch lonenimplantation oder durch Plasmaimplantation durchgeführt wird.

7. Verfahren nach einem der vorhergehenden Ansprüche, wobei die erste Wärmebehandlung während einer Dauer zwischen 30 Minuten und 10 Stunden erfolgt.

8. Verfahren nach einem der vorhergehenden Ansprüche, wobei die erste und die zweite Wärmebehandlung in einer oxidierenden oder neutralen Atmosphäre erfolgen.

9. Verfahren nach einem der vorhergehenden Ansprüche, wobei die zweite Wärmebehandlung bei einer Temperatur von unter 100 °C, vorzugsweise unter 50 °C oder 10 °C der bestimmten Curie-Temperatur und während einer Dauer zwischen 30 Minuten und 10 Stunden erfolgt.

10. Verfahren nach einem der vorhergehenden Ansprüche, wobei das Verfahren zur Herstellung der Dünnschicht (3) einen Polierschritt umfasst, der auf die erste Fläche (8) der Dünnschicht (3) angewendet wird.

11. Verfahren nach einem der vorhergehenden Ansprüche, wobei das Polieren nach der ersten Wärmebehandlung oder nach der zweiten Wärmebehandlung erfolgt.

12. Verfahren nach einem der vorhergehenden Ansprüche, wobei das Donorsubstrat (1) aus Ferroelektrikum auf der Basis von Lithium ist.

13. Verfahren nach vorhergehendem Anspruch, wobei das Donorsubstrat (1) aus LiTaO3 oder aus LiNbO3 ist.

14. Verfahren nach einem der vorhergehenden Ansprüche, wobei das Ferroelektrikum eine Kristallrichtung 42°RY aufweist.

15. Verfahren nach einem der vorhergehenden Ansprüche, wobei das Material des Trägersubstrats (7) Silizium ist.

## Claims

1. Method for preparing a thin layer (3) of alkali-based ferroelectric material, having a predetermined Curie temperature, said layer being transferred from a donor substrate (1) onto a support substrate (7) by a transfer technique including implantation of atomic species into the donor substrate (1) to generate an embrittlement plane (2), the thin layer (3) having a first free face (8) and a second face (4) that is arranged on the support substrate (7), the method for preparing the thin layer (3) being **characterized in that** it includes:
- applying a first heat treatment to the transferred thin layer (3) at a temperature above the predetermined Curie temperature, the thin layer (3) having a multi-domain nature at the end of the first heat treatment;
- after the first heat treatment, introducing protons into the thin layer (3), followed by applying a second heat treatment to the thin layer (3) at a temperature below the predetermined Curie temperature to generate an internal electric field, resulting in the thin layer (3) being made single domain.

2. Method according to the preceding claim, wherein the implanted atomic species are hydrogen ions and/or helium ions.

3. Method according to either of the preceding claims, wherein the transfer technique comprises joining the donor substrate (1) to the support substrate (7) and detaching the thin layer (3) at the embrittlement plane (2).

4. Method according to any of the preceding claims, wherein the introduction of protons into the thin layer (3) is carried out by proton exchange.

5. Method according to the preceding claim, wherein the proton exchange is carried out by immersing at least the thin layer (3) in a bath of benzoic acid at a temperature typically between 200 and 300°C for 10 min to 30 hrs.

6. Method according to any of claims 1 to 3, wherein the introduction of the protons into the thin layer (3) is carried out by ion implantation or by plasma implantation.

7. Method according to any of the preceding claims, wherein the first heat treatment is carried out for a duration between 30 minutes and 10 hours.

8. Method according to any of the preceding claims, wherein the first and the second heat treatment are carried out in an oxidizing or neutral atmosphere.

9. Method according to any of the preceding claims, wherein the second heat treatment is carried out at a temperature within 100°C, preferably within 50°C or 10°C, of the predetermined Curie temperature and for a duration between 30 minutes and 10 hours.

10. Method according to any of the preceding claims, wherein the method for preparing the thin layer (3) includes a polishing step applied to the first face (8) of the thin layer (3).

11. Method according to any of the preceding claims, wherein the polishing takes place after the first heat treatment or after the second heat treatment.

12. Method according to any of the preceding claims, wherein the donor substrate (1) is made of lithium-based ferroelectric material.

13. Method according to the preceding claim, wherein the donor substrate (1) is made of LiTaO3 or of LiNbO3.

14. Method according to any of the preceding claims, wherein the ferroelectric material has a crystal direction of 42°RY.

15. Method according to any of the preceding claims, wherein the material of the support substrate (7) is silicon.
